(19) Europäisches Patentamt
European Patent Office
Office européen des brevets

(11) EP 0 840 655 B1

(12) **EUROPÄISCHE PATENTSCHRIFT**

(45) Veröffentlichungstag und Bekanntmachung des Hinweises auf die Patenterteilung:
**20.01.1999 Patentblatt 1999/03**

(21) Anmeldenummer: **96922770.1**

(22) Anmeldetag: **12.07.1996**

(51) Int. Cl.$^{6}$: **B06B 1/06**

(86) Internationale Anmeldenummer:
**PCT/DE96/01270**

(87) Internationale Veröffentlichungsnummer:
**WO 97/03764 (06.02.1997 Gazette 1997/07)**

(54) **ULTRASCHALLWANDLER**
ULTRASOUND TRANSDUCER
TRANSDUCTEUR ULTRASONORE

(84) Benannte Vertragsstaaten:
**CH DE FR GB IT LI**

(30) Priorität: **24.07.1995 DE 19527018**

(43) Veröffentlichungstag der Anmeldung:
**13.05.1998 Patentblatt 1998/20**

(73) Patentinhaber:
**SIEMENS AKTIENGESELLSCHAFT**
**80333 München (DE)**

(72) Erfinder: **THURN, Rudolf**
**D-92690 Pressath (DE)**

(56) Entgegenhaltungen:
**WO-A-94/05004** **DE-A- 2 541 492**
**GB-A- 766 983** **US-A- 3 928 777**

- **ULTRASONICS, Bd. 27, Nr. 6, 1.November 1989, Seiten 331-342, XP000074701 ANSON L W ET AL: "ON THE PROBLEM OF COUPLING OF ULTRASONIC RECEIVERS TO LAYERED STRUCTURES FOR PROCESS CONTROL"**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 840 655 B1

## Beschreibung

Die Erfindung bezieht sich auf einen Ultraschallwandler mit mindestens einem Piezokeramikkörper zur Aussendung und zum Empfang von Ultraschallwellen in ein flüssiges oder gasförmiges Ausbreitungsmedium , vorzugsweise zum Einsatz in Ultraschall-Näherungsschaltern.

Gattungsgemäße Ultraschallwandler sind durch zahlreiche Veröffentlichungen bekannt. Bei der Anwendung solcher Ultraschallwandler in Ultraschall-Näherungsschaltern und - Distanzsensoren ist unter anderem eine schmale Erfassungscharakteristik gefordert. Objekte können dadurch gezielt erkannt werden, während seitliche Störreflektoren, z. B. in beengten Umgebungen oder in schmalen Gängen, in gewünschter Weise ohne Einfluß auf die Sensorfunktion sind. Es werden hierfür Ultraschall-Wandler benötigt, die eine sehr schmale Schallkeulencharakteristik aufweisen und die zugleich sehr kleine Nebenkeulenamplituden haben.

Aus der DE 25 41 492 C2 ist der richtscharfe Ultraschallwandler in Saturngeometrie bekannt, der bei Ultraschallsensoren im industriellen Einsatz weitverbreitet ist. Er ist aufgebaut aus einer Piezokeramikscheibe, einer Anpaßschichtscheibe und einem konzentrischen Metallring. Durch einen weiten Überstand der Anpaßschichtscheibe über den Durchmesser der Piezokeramikscheibe ist die Fläche der Anpaßschicht groß, wodurch eine sehr schmaler Öffnungswinkel Φ der Schallkeule von 5° erzielt wird. Durch den großen Überstand der Anpassungsschichtscheibe ist es schwierig, die günstige Schwingungsamplitudenverteilung und Phasenlage über der gesamten Fläche in der Praxis immer exakt einzuhalten, so daß es zu problematischen seitlichen Nebenkeulen kommt.

Weiterhin ist ein Ultraschallwandler mit einer Piezokeramikscheibe und einer Silikonanpaßschicht bekannt (siehe US 3 928 777). Die Anpaßschicht hat einen nur wenig größeren Durchmesser als die Piezokeramikscheibe, der Schallkeulen-Öffnungswinkel Φ ist dementsprechend mit 10 - 12° ziemlich groß. Die Nebenkeulen sind mit einer Dämpfung von mehr als -25 dB so gering, daß sie im praktischen Einsatz keine Rolle mehr spielen. Der Anpaßschicht-Werkstoff Silikon ist wegen seiner gEringen Chemikalienbeständigkeit nicht in allen Anwendungsfällen einsetzbar und weist zudem eine starke Temperaturdrift der mechanischen Kenndaten auf.

In der WO 94/05004 ist ein Ultraschallwandler mit seitlicher Rille in der Anpassungsschichtscheibe offenbart. Die Anpaßschicht besteht aus einem robusten und beständigen syntaktischen Schaum wie beim Wandler in Saturngeometrie. Diese Konstruktion weist die gleiche Nebenkeulenfreiheit wie der Wandler mit Silikon auf. Er hat wegen seines ebenfalls geringen Überstands der Anpaßschichtscheibe auch etwa einen gleich großen Schallkeulenöffnungswinkel Φ von 10 - 12°.

Der Erfindung liegt die Aufgabe zugrunde, einen Ultraschallwandler der obengenannten Art mit einem sehr schmalen Hauptkeulenöffnungswinkel zu schaffen, der möglichst gleichzeitig so kleine Nebenkeulenamplituden hat, daß diese bei der praktischen Anwendung keinen störenden Einfluß auf die eigentliche Objekterfassung haben. Die Objekterfassung kann nämlich durch die unbeabsichtigte Erfassung seitlicher Störobjekte verfälscht bzw. erschwert werden, wenn die Nebenkeulenampltuden nicht genügend klein gehalten werden.

Erfindungsgemäß wird die Aufgabe dadurch gelöst, daß der Piezokeramikkörper mindestens auf einer der beiden Grundflächen mit einem plattenförmigen Werkstoffkörper, dessen Schallgeschwindigkeit größer als die des Piezokeramikkörpers ist, zu einem Verbundkörper verbunden ist, dessen Resonanzfrequenz in einer Querschwingungsmode höher ist als die Resonanzfrequenz des Piezokeramikkörpers Die sich daraus ergebende Resonanzfrequenzerhöhung der Quermoden quer zur Dickenrichtung des plattenförmigen Verbundkörpers gegenüber dem isoliert betriebenen Piezokörper führt zu einem schmäleren Schallkeulen-Öffnungswinkel Φ, wenn der Wandler auf einer der frequenzerhöhten Quermoden betrieben wird und wenn eine der Grundflächen als Schallabstrahlfläche verwendet wird. Als plattenförmige Körper werden flache Körper bezeichnet, die in zwei Dimensionen große Abmessungen im Vergleich zu den Abmessungen der dritten Dimension haben, die als Plattendicken bezeichnet werden. Im Fall einer planparallelen Platte gibt es eine einheitliche Plattendicke. Die Dicken der einzelnen plattenförmigen Körper des Verbunds sind dabei mindestens um einen Faktor 2 kleiner als jede der Querabmessungen, die die obere und untere Grundfläche der Platten bilden.

Vorteilhafte Weiterbildungen der Erfindung sind den Unteransprüchen 2 bis 10 zu entnehmen.

Eine vorteilhafte Ausführungsform erhält man, wenn der Piezokeramikkörper als kreisförmige Piezokeramikscheibe und der Werkstoffkörper als kreisförmige Werkstoffscheibe ausgebildet sind. Diese Form führt zu einer rotationssymmetrischen Schallkeule, die bei vielen Anwendungen vorteilhaft ist. Zudem kann hier die Grundschwingung der Planarmode oder Radialschwingung mit hohem Wirkungsgrad als effiziente Wandlerbetriebsmode verwendet werden.

Für bestimmte Anwendungsfälle ist es vorteilhaft, wenn der Piezokeramikkörper und/oder der Werkstoffkörper eine rechteckige oder quadratische Grundfläche haben. Dies führt beispielsweise zu astigmatischen Schallkeulenformen mit unterschiedlich großen Öffnungswinkeln Φ in zwei aufeinander senkrecht stehenden Ebenen längs der Wandlermittelachse. Als Schwingungsmode wird dann z. B. eine der effizienten Quermoden der Längen- oder Breitenabmessung der Rechteckform benutzt.

Eine vorteilhafte Weiterbildung ergibt sich, wenn der Verbundkörper als Schichtverbund mit mindestens zwei Piezokeramikkörpern und mindestens 2 Werkstoffkörpern ausgebildet ist, die in abwechselnder Schichtung miteinander verbunden sind. Durch den Einsatz von mehreren dünnen Plattenkörpern anstelle von wenigen dicken ergibt sich eine bessere Vermengung und eine homogenere Verteilung der mechanischen Werkstoffeigenschaften von Piezokeramikkörper und Werkstoffkörper, so daß selbst bei gleichem Werkstoffkörperanteil höhere resultierende Schallgeschwindigkeiten erzielt werden. Es kann auch vorteilhaft sein, mehrere verschiedene Werkstoffkörpermaterialien und/oder Piezokeramikmaterialien in einem Mehrschichtverbund einzusetzen.

Zur besseren Anpassung an den akustischen Wellenwiderstand des umgebenden Schallausbreitungsmediums wird der Verbundkörper mit mindestens einer Anpassungsschicht versehen, deren Wellenwiderstand zwischen dem des Verbundkörpers und dem des Ausbreitungsmediums liegt. Die Dicke der Anpassungsschicht entspricht vorzugsweise ungefähr einem Viertel der Wellenlänge bei der Betriebsfrequenz des Ultraschallwandlers. Als Anpaßschichtwerkstoff eignet sich syntaktischer Schaum, bestehend aus einer Kunstharzmatrix wie z. B. Epoxidharz, die mit Hohlkörpern aus Glas, Keramik oder Ähnlichem gefüllt ist. Desweiteren eignen sich z. B. leichte Werkstoffe wie Aerogele oder auch gummielastische Werkstoffe wie Silikone.

Kreisförmige Verbundkörperscheiben werden vorzugsweise mit ebenfalls kreisförmigen Anpassungsschicht-Scheiben versehen. Bildet man die Anpassungsschichtscheibe so aus, daß sie einen Durchmesser hat, der gleich dem des Verbundkörpers ist oder innerhalb von 25 % Abweichung ähnlich dem Durchmesser des Verbundkörpers ist, so ergibt sich nach einer Feinabstimmung der Durchmesser- und Dickenwerte der Elemente des Verbundkörpers sowie des Anpassungsschichtkörpers ohne weitere konstruktive Hilfsmittel auf der äußeren, schallabstrahlenden Grundfläche der Anpassungsschicht eine Verteilung von Schwingungsamplitude und -phase, die zu sehr schmalen Schallkeulen mit extrem kleinen Nebenkeulenamplituden führt.

Eine weitere vorteilhafte Ausführungsform des Ultraschallwandlers ergibt sich, wenn die scheibenförmige Anpassungsschicht auf ihrer Mantelfläche und/oder auf ihrer inneren Grundfläche mit einer angepaßten Kontur versehen ist. Diese besteht z.B. aus mindestens einer Einbuchtung und/oder Ausbuchtung, die beispielsweise einen runden, dreieckförmigen, rechteckförmigen oder trapezförmigen Querschnitt aufweist. Die angepaßte Kontur kann einfach auch darin bestehen, daß die seitliche Mantelfläche der Anpassungsschichtscheibe im Querschnitt von schräger Form mit geradlinigem oder gebogenem Verlauf ist, so daß die äußere und die innere Grundfläche der Anpassungsschicht unterschiedliche Größen haben. Eine angepaßte Kontur kann sich auch auf der inneren Grundfläche der Anpassungsschicht befinden, die hier z. B. die Form von konzentrischen Rillen aufweist. Mit diesen zusätzlichen Maßnahmen können gewünschte Wandlereigenschaften wie z. B. bestimmte anwendungsangepaßte Schallkeulenformen in gezielter Weise eingestellt werden.

Weiterhin ist es vorteilhaft, wenn die Anpassungsschicht als zylinderförmige Scheibe mit einem Durchmesser ausgebildet ist, der größer als das 1,25fache des größten Durchmessers des Verbundkörpers ist, wobei der über den Durchmesser des Verbundkörpers überstehende Bereich der Anpassungsschicht auf seiner der schallabstrahlenden Oberfläche abgewandten Rückseite konzentrisch mit einem ringförmigen Körper aus Metall oder aus dem Werkstoff der Anpassungsschicht selbst versehen ist. Bei dieser Ausführung werden durch die Vergrößerung der Abstrahlfläche sehr schmale Schallkeulen erreicht und zugleich dafür gesorgt, daß der überstehende Bereich der Anpassungsschicht weitgehend gleichphasig mit dem zentralen Bereich schwingt. Insofern besteht Übereinstimmung mit bekannten Wandlern in Saturn-Geometrie, bei denen ebenfalls der überstehende Bereich der Anpassungsschicht auf seiner der vorderen Abstrahlgrundfläche gegenüber liegenden Rückseite konzentrisch mit einem flachen, ringförmigen Körper aus Metall versehen ist.

Ausführungsformen der Erfindung werden im folgenden anhand einer Zeichnung erläutert. Es zeigen:

FIG 1 ein Schnittbild eines zylinderförmigen, symmetrisch aufgebauten Ultraschallwandlers mit einer kreisförmigen Piezokeramikscheibe, beidseits umgeben von je einer kreisförmigen Werkstoffkörperscheibe,

FIG 2 ein Schnittbild eines kreisförmigen Ultraschallwandlers mit einer Werkstoffkörperscheibe, einer Piezokeramikscheibe sowie einer Anpassungsschichtscheibe,

FIG 3 ein Schnittbild eines kreisförmigen Ultraschallwandlers mit einer Piezokeramikscheibe, einer Werkstoffkörperscheibe und einer Anpassungsschichtscheibe mit angepaßter Kontur auf der Mantelfläche,

FIG 4 ein Schnittbild eines kreisförmigen Ultraschallwandlers mit einem Mehrschichtverbund aus jeweils zwei Piezokeramikscheiben und zwei Werkstoffkörperscheiben, versehen mit einer Anpassungschichtscheibe,

FIG 5 ein Diagramm mit einer graphischen Darstellung des Zusammenhangs zwischen wirksamer Schallgeschwindigkeit und prozentualem Anteil des Werkstoffkörpers in einem symmetrischen Verbund entsprechend Fig. 1, und

FIG 6 ein Schnittbild eines rotationssymmetrischen Ultraschallwandlers mit einer Piezokeramikscheibe, einer Werkstoffkörperscheibe, einer Anpassungsschichtscheibe mit großem Überstand und mit einem konzentrischen Metallring auf der Rückseite der Anpassungsschichtscheibe.

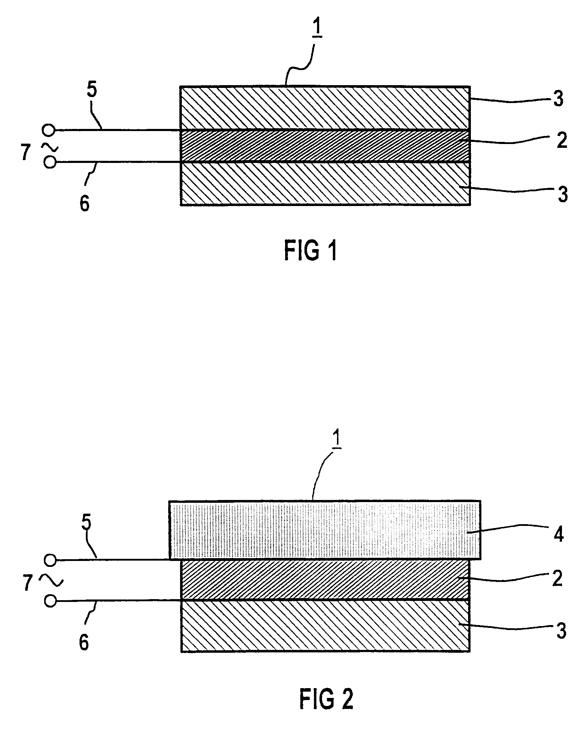

FIG 1 zeigt beispielhaft einen Ultraschallwandler 1 mit einer Piezokeramikscheibe 2 mit kreisförmigen planparallelen Grundflächen als Piezokeramikkörper, der an beiden Stirnseiten mit einer Werkstoffscheibe 3 als Werkstoffkörper verbunden ist. Die Piezokeramikscheibe 2 führt bei elektrischer Anregung über Kontaktierungsdrähte 5, 6, die eine Erregerspannung 7 mit den nicht dargestellten, stirnseitigen Elektrodenflächen der Piezokeramikscheibe 2 verbinden, radiale Planarschwingungen aus. Die Resonanzfrequenz der Planarmode, einer Quermode mit radialer Schwingerrichtung, wird bestimmt durch den Scheibendurchmesser und durch die Schallgeschwindigkeit des Piezomaterials und berechnet sich für dünne Scheiben zu $f_p = 2 * C_D / (\pi * d)$, wobei $f_p$= Planar-Serienresonanzfrequenz, d = Scheibendurchmesser und $C_D$ = Schallgeschwindigkeit der Dehnwelle. $C_D$ berechnet sich dabei zu:

$$c_D = \sqrt{E / (\rho * (1 - \mu^2))},$$

wobei E = Elastizitatsmodul, $\rho$ = Dichte und $\mu$ = Poissonzahl. Bei gegebenem Durchmesser wird die Resonanzfrequenz durch die Schallgeschwindigkeit im Piezomaterial bestimmt. Durch die Verbindung der Piezokeramikscheibe 2 mit den Werkstoffscheiben 3, die eine höhere Schallgeschwindigkeit als die Piezokeramikscheibe 2 haben, zu einem Verbundkörper resultiert eine höhere wirksame Schallgeschwindigkeit desselben gegenüber der Piezokeramikscheibe 2; die wirksame Schallgeschwindigkeit liegt zwischen der des Piezokeramikkörpers und der des Werkstoffkörpers. Dadurch ist die Grundresonanzfrequenz der Planarmode des Verbundkörpers bei gleichbleibendem Durchmesser gegenüber der Resonanzfrequenz der isoliert betriebenen Piezokeramikscheibe 2 erhöht, wodurch der Öffnungswinkel $\Phi$ der Hauptschallkeule der ausgesendeten Ultraschallwellen verkleinert wird. Denn es gilt der Zusammenhang, daß der Öffnungswinkel $\Phi$ umso kleiner ist, je größer das Verhältnis von Abstrahlfläche zu Wellenlänge der in das umgebende Medium abgestrahlten Schallwelle ist.

Heute üblicherweise eingesetzte synthetische piezoelektrische Keramiken aus Blei-Zirkonat-Titanat-Verbindungen (PZT) haben als Scheiben eine maximale Dehnwellenschallgeschwindigkeit von ca. 3500 m/s. Bariumtitanat-Keramik hat eine höhere Schallgeschwindigkeit, kann aber wegen der niedrigen Curie-Temperatur für viele industrielle Anwendungen nicht eingesetzt werden. Mit der erfindungsgemäßen Lösung des Verbundkörpers aus Piezokeramik und Werkstoffkörper kann ein künstlicher „Piezokörper" mit viel höherer Schallgeschwindigkeit und Resonanzfrequenz erzeugt werden. Als Werkstoffkörper bieten sich Werkstoffe mit hohen Schallgeschwindigkeiten an. Dazu gehören unter anderem Werkstoffe wie Silizium, Siliziumdioxid, Siliziumnitrid, Siliziumkarbid oder auch Aluminiumoxid. Unter den Metallen wäre Beryllium zu nennen, dessen Schallgeschwindigkeitswert bei ca. 12600 m/s liegt. Spezielle Stahllegierungen, Nickellegierungen wie Inconel, Titan und Aluminium usw. haben ebenfalls hohe Schallgeschwindigkeiten. Eine weitere Werkstoffeigenschaft des Werkstoffkörpers ist die mechanische Schwinggüte; falls ein Wandler mit hoher akustischer Empfindlichkeit geschaffen werden soll, wird ein Werkstoff mit hoher Schwinggüte gewählt. Fur den Fall eines breitbandigen Wandlers verwendet man einen Werkstoff mit niedrigerer Schwinggüte.

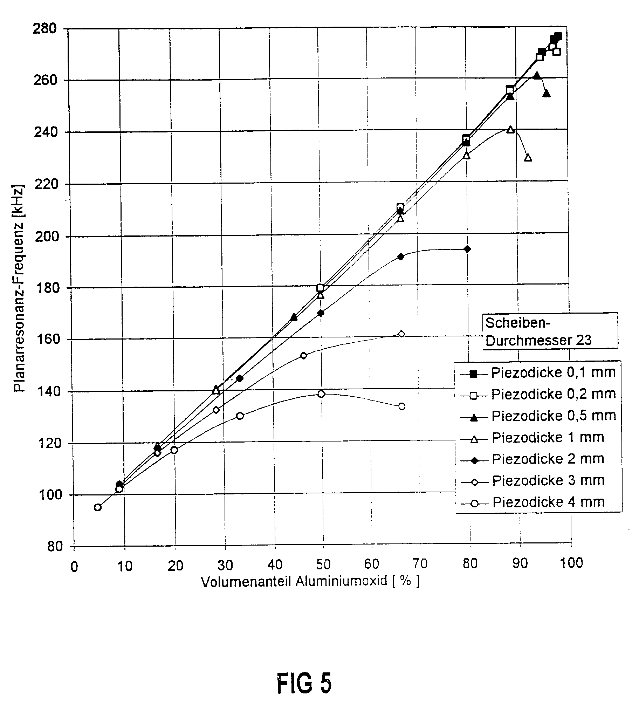

Durch den Verbund des Piezokeramikkörpers mit dem Werkstoffkörper kann die wirksame Schallgeschwindigkeit und damit die Planarresonanzfrequenz des Verbunds beträchtlich erhöht werden. Verwendet man für den Piezokeramikkörper beispielweise eine PZT-Scheibe mit einem Durchmesser von 23 mm und einer Dicke von 2 mm, so liegt die Planarresonanzfrequenz dieser Scheibe bei 86 kHz. Eine Werkstoffscheibe gleicher Abmessungen aus Aluminiumoxid hat seine Planarresonanz bei 282 kHz. Verbindet man analog der Geometrie aus Fig. 1 z.B. durch Verkleben die genannte Piezokeramikscheibe konzentrisch an ihren beiden Grundflächen mit je einer der genannten Aluminiumoxidscheiben, so ergibt sich für den Verbund eine Planarresonanzfrequenz von 191 kHz. Für den beispielhaften Fall, daß bei obigem Durchmesser die PZT-Scheibe 0,5 mm dick ist und die Aluminiumoxidscheibe 2 mm dick ist, ergibt sich für den Verbund eine Planarresonanzfrequenz von 253 kHz. Für den Fall, daß die PZT-Scheibe 0,1 mm dick ist und die Aluminiumoxidscheibe 2 mm dick ist, ergibt sich für den Verbund eine Planarresonanzfrequenz von 275 kHz. Die Abhängigkeit der resultierenden Planar-Resonanzfrequenz von den Geometrieabmessungen des symmetrischen Verbunds aus einer PZT-Scheibe mit zwei durchmessergleichen Aluminiumoxidscheiben gemäß der Geometrie von Fig. 1 ist in dem Diagramm von Fig. 5 für die PZT-Scheibendicken 0.1, 0.2, 0.5, 1, 2, 3 und 4 mm dargestellt. Für kleine Dickenwerte des Verbundkörpers ergibt sich die resultierende Resonanzfrequenz zwischen PZT-Resonanz und Aluminiumoxidresonanz proportional zum volumenmäßigen Anteil des Aluminiumoxids am Gesamtvolumen des Verbunds. Fur Volumenanteile nahe 0 % bzw. nahe 100 % Aluminiumoxid nähert sich die Resonanzfrequenz asymptotisch den Resonanzfrequenzen von PZT-Scheibe bzw. Aluminiumoxidscheibe an. Eine Abweichung zu niedrigeren resultierenden Frequenzen ergibt sich für größere Scheibendicken und für Gesamtdicken des Verbundkörpers ab etwa einem Drittel des Durchmessers. Ursache für dieses Verhalten ist schlechtere Schwingungskopplung bei dickeren Scheiben bzw. die Wechselwirkung der Planarmode mit der Dickenmode des Verbundkörpers.

Bei Verwendung von Aluminiumoxid kann die Planarfrequenz des Verbunds bei gleichbeibendem Durchmesser um mehr als Faktor 3 gegenüber der PZT-Scheibe erhöht werden; kleinere Werte der Planarfrequenz sind durch Wahl der geeigneten Kombination von Piezodicke und Werkstoffdicke praktisch stufenlos einstellbar (siehe Fig. 5). Die Regel dabei ist, daß die Frequenz umso höher ist, je höher die Eigenresonanzfrequenz des Werkstoffkörpers selbst ist, je höher der relative Werkstoffkörperanteil ist und je dünner die Piezodicke ist. Bei einer Frequenzerhöhung um den Faktor 3 reduziert sich die Schallkeulenbreite in demselben Maß. Liegt die -3dB - Breite des Öffnungswinkels Φ bei der isoliert betriebenen PZT-Scheibe bei ca. 12°, so ergibt sich durch die Reduzierung um Faktor 3 eine Keulenbreite Φ von 4°. Wird als Werkstoffkörper z. B. Siliziumkarbid oder Beryllium verwendet, deren Schallgeschwindigkeit über der von Aluminiumoxid liegt, so ergeben sich entsprechend noch höhere resultierende Resonanzfrequenzen, so daß hiermit Öffnungswinkel Φ von etwa 3° erzielt werden. Verbundgeometrien mit geringeren Frequenzerhöhungen fuhren zu entsprechend proportional breiteren Schallkeulen, so daß durch einfache Wahl der geeigneten Kombination von Piezokörpermaterial und -dicke und Werkstoffkörpermaterial und -dicke die Möglichkeit besteht, praktisch alle Keulenöffnungswinkel Φ zwischen ca. 3° und 12° stufenlos zu realisieren. Eine maßstäbliche Vergrößerung oder Verkleinerung führt in bekannter Weise zu Wandlern mit gleichen Schallkeulenformen bei entsprechend höheren bzw. niedrigeren Betriebsfrequenzen.

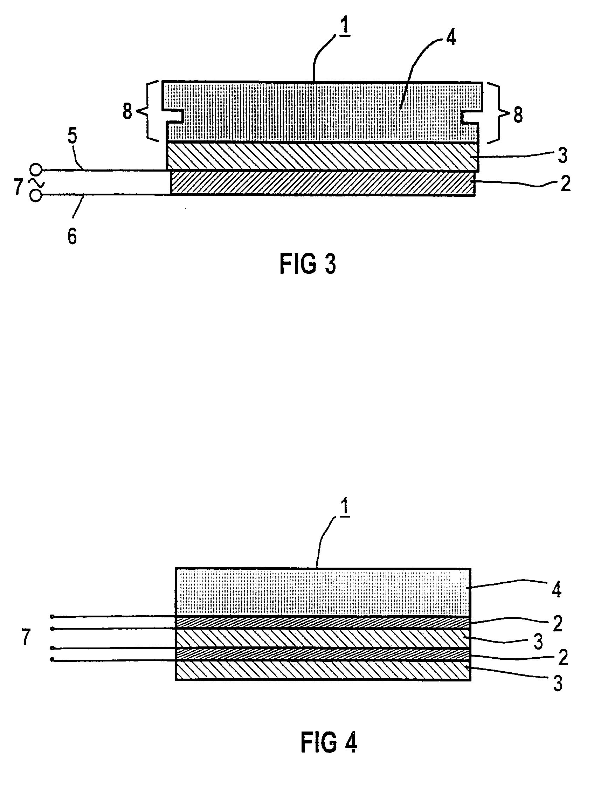

Fig. 2 zeigt einen Ultraschall-Wandler 1 mit einer PZT-Scheibe 2 mit Durchmesser 23 mm und Dicke 2,5 mm, die an ihrer rückseitigen Grundfläche mit einer durchmessergleichen Aluminiumoxidscheibe 3 mit 3,5 mm Dicke sowie an ihrer vorderen Grundfläche mit einer Anpassungsschichtscheibe 4 aus Epoxid-Glashohlkugel-Gemisch mit einem Durchmesser von 24 mm und einer Dicke von 3,2 mm versehen ist. Die Betriebsfrequenz dieses beispielhaften Wandlers liegt bei 160 kHz, bei einer Breite Φ der Hauptkeule von 6° und bei einer Nebenkeulendampfung von besser als -25 dB. Fig. 3 zeigt einen Wandler 1 mit einer PZT-Scheibe 2, an deren einen Grundfläche eine Werkstoffkörperscheibe 3 angebracht ist. Diese wiederum ist mit einer Anpassungsschichtscheibe 4 verbunden, die auf ihrer Mantelfläche mit einer angepaßten Kontur 8 versehen ist. Die Dicken der PZT-Scheiben und der Aluminiumoxidscheiben liegen für die Geometrien von Fig. 2 und Fig. 3 vorzugsweise zwischen 5 % und 20% des Scheibendurchmessers.

In Fig. 4 ist ein einfach aufgebauter, zylinderförmiger Ultraschall-Wandler 1 mit einem Mehrschichtverbundkörper dargestellt, der aus zwei PZT-Scheiben 2 und zwei Aluminiumoxidscheiben 3 aufgebaut ist. An der oberen PZT-Scheibe ist eine Anpassungsschichtscheibe 4 aus einem Epoxid-Glashohlkugel-Gemisch angebracht. Vorteilhafte Dicken von Piezokeramikscheibe und Werkstoffkörperscheibe liegen bei diesem Mehrschichtverbund oder auch bei artverwandten Konstruktionen mit noch mehr Schichtelementen zwischen etwa 0,5 % und 15 % des Scheibendurchmessers. Die einzelnen Schichtelemente des beispielhaften Wandlers 1 haben einen einheitlichen Durchmesser von 23 mm. Die Dicke der beiden PZT-Scheiben 2 beträgt jeweils 0.5 mm, die Dicke der Aluminiumoxidscheiben 3 ist jeweils 1 mm und die Anpassungsschichtscheibe 4 ist 2.1 mm dick. Der Wandler 1 hat eine Betriebsfrequenz von 265 kHz, eine Breite Φ der Hauptkeule von 4° und eine Nebenkeulendämpfung von besser als -30 dB.

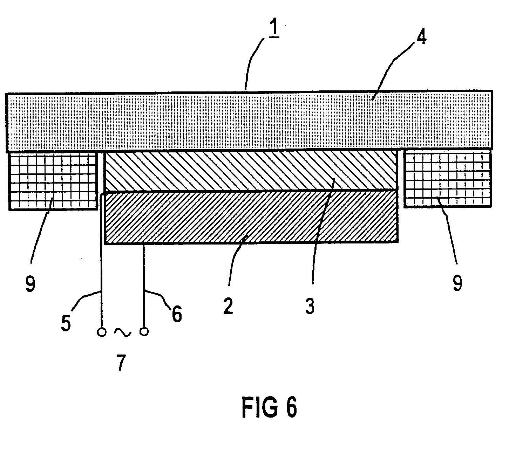

Die FIG 6 zeigt einen Ultraschallwandler 1, der ähnlich der Saturn-Geometrie aufgebaut ist, mit einer PZT-Scheibe 2, einer Werkstoffkörperscheibe 3 gleichen Durchmessers und einer Anpaßschichtscheibe 4 aus einem Epoxid-Glashohlkugel-Gemisch mit einem deutlich größeren Durchmesser als der des PZT-Werkstoffkörper-Verbunds 2,3. Damit der überstehende, äußere Teil der Anpaßschichtscheibe 4 phasenrichtig mit dem zentralen Teil schwingt, ist auf der der schallabstrahlenden vorderen Grundfläche gegenüberliegenden Rückseite des überstehenden Teiles der Anpaßschicht 4 konzentrisch eine ringförmige Lochscheibe 9 aus Metall angebracht. Durch die somit stark vergrößerte Abstrahlfläche werden damit Öffnungswinkel Φ der Schallkeule von unter 3°, in der Nähe von 2° möglich.

## Patentansprüche

1. Ultraschall-Wandler (1) mit mindestens einem plattenförmigen Piezokeramikkörper (2) mit jeweils einer oberen und einer unteren Grundfläche zur Aussendung von Ultraschallwellen in ein flüssiges oder gasförmiges Ausbreitungsmedium, vorzugsweise zum Einsatz in Näherungsschaltern, **dadurch gekennzeichnet,** daß der Piezokeramikkörper (2) mindestens auf einer der beiden Grundflächen mit einem plattenförmigen Werkstoffkörper (3), dessen Schallgeschwindigkeit größer als die des Piezokeramikkörpers (2) ist, zu einem Verbundkörper (2,3) verbunden ist, dessen Resonanzfrequenz in einer Querschwingungsmode höher ist als die Resonanzfrequenz des Piezokeramikkörpers (2).

2. Ultraschall-Wandler nach Anspruch 1, **dadurch gekennzeichnet,** daß die Grundflächen des Piezokeramikkörpers (2) und des Werkstoffkörpers (3) ähnlich groß sind und daß sie flächenmäßig um nicht mehr als 50 % voneinander abweichen.

3. Ultraschall-Wandler nach Anspruch 1 oder 2, **dadurch gekennzeichnet,** daß der Piezokeramikkörper als kreisförmige Piezokeramikscheibe (2) und der Werkstoffkörper als kreisförmige Werkstoffscheibe (3) ausgebildet sind.

4. Ultraschall-Wandler nach Anspruch 1 oder 2, **dadurch gekennzeichnet,** daß der Piezokeramikkörper (2) und/oder der Werkstoffkörper (3) eine rechteckige oder quadratische Grundfläche haben.

5. Ultraschall-Wandler nach einem der vorangehenden Ansprüche, **dadurch gekennzeichnet,** daß der Verbundkörper(2,3) als Schichtverbund mit mindestens zwei Piezokeramikkörpern (2) und mindestens zwei Werkstoffkörpern (3) ausgebildet ist, die in abwechselnder Schichtung miteinander verbunden sind.

6. Ultraschall-Wandler nach einem der vorangehenden Ansprüche, **dadurch gekennzeichnet,** daß der Verbundkörper (2,3) an einer Grundfläche mit mindestens einer plattenförmigen Anpassungsschicht (4) zur Anpassung an den Wellenwiderstand des umgebenden Ausbreitungsmediums versehen ist, deren äußere Grundfläche die schallabstrahlende Oberfläche des Ultraschall-Wandlers (1) darstellt.

7. Ultraschall-Wandler nach Anspruch 6, **dadurch gekennzeichnet,** daß die Anpassungsschicht (4) von der Form einer kreisförmigen Scheibe ist, deren Durchmesser um nicht mehr als 25 % vom größten Durchmesser des Verbundkörpers (2,3) abweicht.

8. Ultraschall-Wandler nach Anspruch 6 oder 7, **dadurch gekennzeichnet,** daß die scheibenförmige Anpassungsschicht (4) auf ihrer Mantelfläche und/oder auf ihrer inneren Grundfläche mit einer angepaßten Kontur (8) versehen ist.

9. Ultraschall-Wandler nach Anspruch 6 oder 8 , **dadurch gekennzeichnet,** daß die Anpassungsschicht (4) als zylinderförmige Scheibe mit einem Durchmesser ausgebildet ist, der größer als das 1,25 fache des größten Durchmessers des Verbundkörpers (2,3) ist, wobei der über den Durchmesser des Verbundkörpers (2,3) überstehende Bereich der Anpassungsschicht (4) auf seiner der schallabstrahlenden Oberfläche abgewandten Rückseite konzentrisch mit einem ringförmigen Körper aus Metall oder aus dem Werkstoff der Anpassungsschicht (4) selbst versehen ist.

10. Ultraschall-Wandler nach einem der vorangehenden Ansprüche, **dadurch gekennzeichnet,** daß der Ultraschall-Wandler (1) in einen elastischen, schwingungsdämpfenden Werkstoff eingebettet ist.

## Claims

1. Ultrasonic transducer (1) having at least one plate-shaped piezoceramic body (2) with in each case an upper and a lower base face for emitting ultrasonic waves into a liquid or gaseous propagation medium, preferably for use in proximity switches, characterized in that, at least on one of the two base faces the piezoceramic body (2) is connected to a plate-shaped material body (3), whose speed of sound is higher than that of the piezoceramic body (2), to form a composite body (2, 3) whose resonant frequency is higher in one transverse vibration mode than the resonant frequency of the piezoceramic body (2).

2. Ultrasonic transducer according to Claim 1, characterized in that the base faces of the piezoceramic body (2) and of the material body (3) are of similar size, and in that they deviate from one another by no more than 50% in terms of area.

3. Ultrasonic transducer according to Claim 1 or 2, characterized in that the piezoceramic body is constructed as a circular piezoceramic disc (2), and the material body is constructed as a circular material disc (3).

4. Ultrasonic transducer according to Claim 1 or 2, characterized in that the piezoceramic body (2) and/or the material body (3) have a rectangular or square base face.

5. Ultrasonic transducer according to one of the preceding claims, characterized in that the composite body (2, 3) is constructed as a layered assembly with at least two piezoceramic bodies (2) and at least two material bodies (3) which are interconnected by alternate layering.

6. Ultrasonic transducer according to one of the preceding claims, characterized in that the composite body (2, 3) is provided on one base face with at least one plate-shaped adapting layer (4) for adaptation to the characteristic impedance of the surrounding propagation medium, the outer base face of which constitutes the sound-emitting surface of the ultrasonic transducer (1).

7. Ultrasonic transducer according to Claim 6, characterized in that the adapting layer (4) is in the shape of a circular disc whose diameter deviates from the largest diameter of the composite body (2, 3) by not more than 25%.

8. Ultrasonic transducer according to Claim 6 or 7, characterized in that the disc-shaped adapting layer (4) is provided with an adapted contour (8) on its lateral surface and/or on its inner base face.

**9.** Ultrasonic transducer according to Claim 6 or 8, characterized in that the adapting layer (4) is constructed as a cylindrical disc with a diameter which is larger than 1.25 times the largest diameter of the composite body (2, 3), that region of the adapting layer (4) which projects beyond the diameter of the composite body (2, 3) being provided concentrically on its rear side averted from the sound-emitting surface with an annular body made from metal or from the material of the adapting layer (4) itself.

**10.** Ultrasonic transducer according to one of the preceding claims, characterized in that the ultrasonic transducer (1) is embedded in an elastic, vibration-damping material.

## Revendications

**1.** Transducteur d'ultrasons (1) comportant au moins un corps céramique piézo-électrique (2) en forme de plaque ayant une base supérieure et une base inférieure pour l'émission d'ondes ultrasonores dans un milieu de propagation liquide ou gazeux, de préférence en vue d'une utilisation dans des détecteurs de proximité, caractérisé par le fait que le corps céramique piézo-électrique (2) est accolé par au moins l'une des deux bases à un corps de matériau (3) en forme de plaque, dont la vitesse d'ultrasons est supérieure à celle du corps céramique piézo-électrique (2), pour former un corps composite (2, 3) dont la fréquence de résonance dans un mode d'oscillation transversale est supérieure à la fréquence de résonance du corps céramique piézo-électrique (2).

**2.** Transducteur d'ultrasons selon la revendication 1, caractérisé par le fait que les bases du corps céramique piézo-électrique (2) et du corps de matériau (3) sont de grandeur identique et que leur surface ne se différencient pas l'une de l'autre de plus de 50 %.

**3.** Transducteur d'ultrasons selon la revendication 1 ou 2, caractérisé par le fait que le corps céramique piézo-électrique est sous la forme d'une plaque céramique piézo-électrique (2) circulaire et le corps de matériau d'une plaque de matériau (3) circulaire.

**4.** Transducteur d'ultrasons selon la revendication 1 ou 2, caractérisé par le fait que le corps céramique piézo-électrique (2) et/ou le corps de matériau (3) ont une base rectangulaire ou carrée.

**5.** Transducteur d'ultrasons selon l'une des revendications précédentes, caractérisé par le fait que le corps composite (2, 3) est sous la forme d'un corps composite à plusieurs couches ayant au moins deux corps céramiques piézo-électriques (2) et au moins deux corps de matériau (3) qui sont assemblés selon une disposition en couches alternées.

**6.** Transducteur d'ultrasons selon l'une des revendications précédentes, caractérisé par le fait que le corps composite (2, 3) est muni sur une base d'au moins une couche d'adaptation (4) en forme de plaque qui est destinée à l'adaptation à l'impédance caractéristique du milieu de propagation environnant et dont la base extérieure représente la surface émettrice d'ultrasons du transducteur d'ultrasons (1).

**7.** Transducteur d'ultrasons selon la revendication 6, caractérisé par le fait que la couche d'adaptation (4) a la forme d'un disque dont le diamètre ne s'écarte pas de plus de 25 % du plus grand diamètre du corps composite (2, 3).

**8.** Transducteur d'ultrasons selon la revendication 6 ou 7, caractérisé par le fait que la couche d'adaptation (4) en forme de disque est munie sur sa surface latérale et/ou sur sa base intérieure d'un contour (8) adapté.

**9.** Transducteur d'ultrasons selon la revendication 6 ou 8, caractérisé par le fait que la couche d'adaptation (4) est sous la forme d'une plaque cylindrique d'un diamètre supérieur à 1,25 fois le plus grand diamètre du corps composite (2, 3), la partie de la couche d'adaptation (4) qui dépasse du diamètre du corps composite (2,3) étant munie, sur sa face arrière opposée à la surface émettrice d'ultrasons, d'un corps annulaire concentrique en métal ou en le même matériau que la couche d'adaptation (4).

**10.** Transducteur d'ultrasons selon l'une des revendications précédentes, caractérisé par le fait que le transducteur d'ultrasons (1) est noyé dans un matériau élastique amortissant les oscillations.

1
5
3
2
7
6
3

FIG 1

1
5
4
2
7
6
3

FIG 2

1
4
8
8
5
3
7
2
6

FIG 3

1
4
2
7
3
2
3

FIG 4

280
260
240
220
200
180
160
140
120
100
80
Planarresonanz-Frequenz [kHz]
0
10
20
30
40
50
60
70
80
90
100
Volumenanteil Aluminiumoxid [ % ]
Scheiben-
Durchmesser 23
Piezodicke 0,1 mm
Piezodicke 0,2 mm
Piezodicke 0,5 mm
Piezodicke 1 mm
Piezodicke 2 mm
Piezodicke 3 mm
Piezodicke 4 mm

FIG 5

1
4
9
9
5
6
2
3
7

FIG 6